# EUROPEAN PATENT SPECIFICATION

(11) **EP 0 717 126 B1**
(45) Date of publication and mention of the grant of the patent: **05.09.2001**
(21) Application number: 95309190.7
(22) Date of filing: 18.12.1995
(51) Int. Cl.: C23C 16/44, C30B 25/14, C23C 16/50

(54) **Apparatus for low pressure chemical vapor deposition**
Vorrichtung zur chemischen Dampfabscheidung bei niedrigem Druck
Appareil de dépôt chimique en phase vapeur à basse pression

(30) Priority: 16.12.1994 KR 3461794; 21.01.1995 KR 1002995; 01.04.1995 KR 6502095; 01.08.1995 KR 2366895
(43) Date of publication of application: 19.06.1996
(73) Proprietor: Hwang, Chul-Ju, Sungnam-Shi, Kyungki-Do (KR)
(72) Inventor: Hwang, Chul-Ju, Sungnam-Shi, Kyungki-Do (KR)
(74) Representative: Beresford, Keith Denis Lewis

(56) References cited:
- EP-A- 0 382 988
- EP-A- 0 478 908
- GB-A- 2 256 085
- US-A- 5 329 095
- US-A- 5 370 371
- PATENT ABSTRACTS OF JAPAN vol. 010, no. 175 (E-413), 20 June 1986 & JP-A-61 026218 (MATSUSHITA DENKI SANGYO KK), 5 February 1986,
- PATENT ABSTRACTS OF JAPAN vol. 008, no. 231 (E-274), 24 October 1984 & JP-A-59 112615 (MATSUSHITA DENKI SANGYO KK), 29 June 1984,
- PATENT ABSTRACTS OF JAPAN vol. 008, no. 243 (E-277), 8 November 1984 & JP-A-59 121915 (HITACHI SEISAKUSHO KK), 14 July 1984,
- PATENT ABSTRACTS OF JAPAN vol. 014, no. 459 (C-0767), 4 October 1990 & JP-A-02 185978 (KOKUSAI ELECTRIC CO LTD), 20 July 1990,

## Description

The present invention relates to an apparatus for low pressure chemical vapour deposition, and particularly to an improved apparatus for plasma enhanced low pressure chemical vapour deposition capable of achieving fabrication of various kinds of thin films having a uniform thickness, and which is well suited for automation. It also concerns a method of preparing a semiconductor wafer by plasma enhanced low pressure chemical vapour deposition, and a method of producing a semiconductor device in accordance with said method of preparation.

As well known to those skilled in the art, the low pressure chemical vapour deposition (hereinafter called an "LPCVD") technique has been widely used so as to deposit nitride layers, oxide layers, silicon layers, and the like on a wafer having insulating, dielectric or conductive characteristics.

The deposition apparatus adopted for LPCVD is directed to depositing a compound thin film on a wafer by reacting a chemical source gas in a reactor under a low pressure. This apparatus includes a single wafer input low pressure chemical vapour deposition device for depositing while loading wafers one by one and a vertical type low pressure chemical vapour deposition device for depositing in a state that a plurality of wafers are loaded. In addition, the single wafer input low pressure chemical vapour deposition apparatus has an advantage in that it is easy to automate the system.

Hereinafter, only the single wafer input low pressure chemical vapour deposition apparatus of the conventional low pressure chemical vapour deposition apparatuses will now be explained.

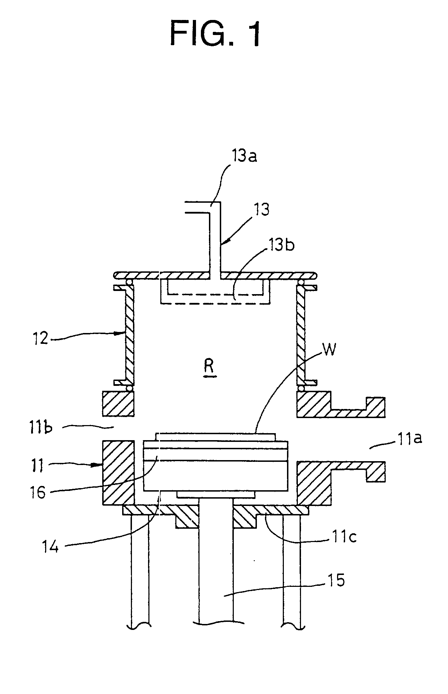

Fig. 1 shows a conventional single wafer input low pressure chemical vapour deposition apparatus, which includes a supporting base 11 having a wafer inlet 11a and an outlet 11b for discharging reaction substances and which is opened/closed by an opening/closing plate 11c, a reactor 12 disposed above the supporting base 11 for forming a reaction space "R", a chemical source gas introducer 13 disposed on the upper portion of the reactor 12, and a stage 14 which is lifted/lowered within the reaction space "R" by a lifting/lowering ram 15 passing through the opening/closing plate 11c.

The above-mentioned conventional single wafer input low pressure chemical vapour deposition apparatus is directed to placing a wafer "W" on the stage 14 by introducing the wafer "W" through the wafer inlet 11a in a state that the stage 14 is lowered down to a loading/unloading position lower than the wafer inlet 11a, and lifting the stage 14 using the lifting/lowering ram 15, driving a stage heating member 16 disposed at the stage 14, and introducing a chemical source gas into the reactor 12 through a chemical source gas introducer 13, whereby the chemical source gas is deposited on the wafer "W" so as to form a compound thin film.

However, the conventional single wafer input low pressure chemical vapour deposition apparatus has disadvantages in that when heat is applied to the stage 14 having a wafer "W", since the heat is not applied to the reactor 12 and its periphery, the thermal effect is deteriorated. Due to the above-mentioned thermal effect, pin holes occur in the thin film, and step coverage is poor.

In addition, because the conventional single wafer input low pressure chemical vapour deposition apparatus provides the chemical source gas introducer 13, connected to a lower portion of the introduction tube 13a passing through the upper surface of the reactor 12, and a shower head 13b having a plurality of shower apertures so as to simply eject chemical source gas, so that a desired compound mixing cannot be achieved, whereby a non-uniform layer can be deposited on the entire wafer surface.

Moreover, in order to overcome the above-mentioned problems, the plasma enhanced low pressure chemical vapour deposition apparatus has been introduced. It is characterised by reacting the chemical source gas by generating plasma by connecting a plasma generator between the stage (anode) and the electrode (cathode) of the reactor.

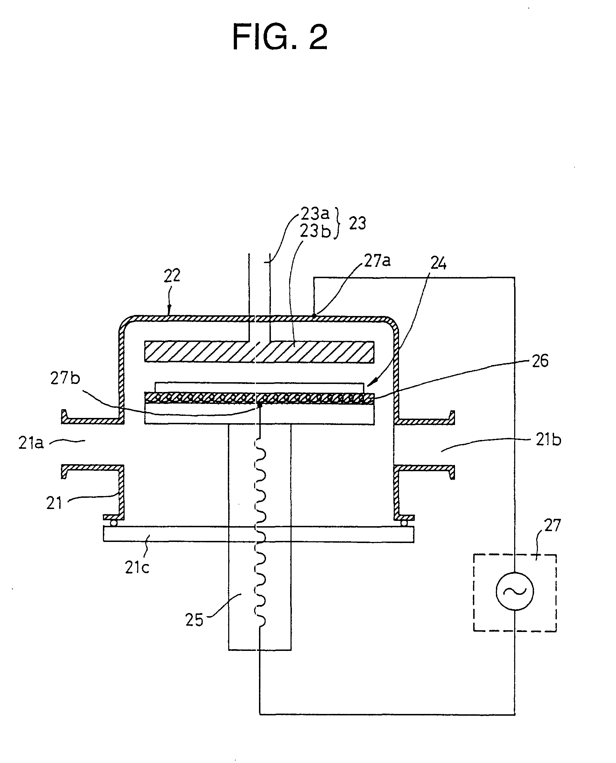

As shown in Fig. 2, the conventional plasma enhanced low pressure chemical vapour deposition apparatus includes a supporting base 21 having an inlet 21a formed at one side thereof and an outlet 21b formed at the other side thereof, wherein the lower portion thereof is opened/closed by an opening/closing plate 21c, a reactor 22 disposed at an upper portion of the supporting base 21, a chemical source gas introducer 23 disposed at the upper surface of the reactor 22, a stage 24 on which a wafer "W", which can be lifted/lowered within the reactor 22 by a lifting/lowering ram 25 through the opening/closing plate 21c, is mounted, a stage heating member 26 disposed in the stage 24, and a plasma generator 27 connected between the reactor 22 and the stage 24 by electrode connections 27a and 27b.

The above-mentioned conventional plasma enhanced low pressure chemical vapour deposition apparatus is directed to depositing a compound thin film on a wafer "W" by lowering the lifting/lowering ram 25 through the opening/closing plate 21c and the stage 24 down to a loading/unloading position lower than the inlet 21a, by mounting the wafer "W" on the stage 24 through the inlet 21a, and by generating plasma in the reactor 22 by driving the plasma generator 27 connected to the electrode terminals 27a and 27b mounted on an upper portion of the reactor 22 and the stage 24 while introducing the chemical source gas into the reactor 22 through the chemical source gas introducer 23 and while heating the stage and the wafer "W" by driving the stage heating member 26 after lifting the stage 24 with the wafer "W" up to the deposition position.

The above-mentioned plasma enhanced low pressure chemical vapour deposition apparatus has advantages in that it can minimise the characteristic variation of a device due to deposition temperature by maintaining the process temperature at a low temperature by ionising the chemical source gas by generating plasma. However, it has disadvantages in that the heat distribution is uneven because the chemical source gas is introduced into a reaction space "S" in a state that the chemical source gas is not substantially heated since only the substrate 24, on which the wafer "W" is mounted is heated, and its periphery is not substantially heated. In addition, pin holes can occur in the thin film due to the above-mentioned uneven heat distribution, and step coverage is poor.

Moreover, because the chemical source gas introducer 23 is simply connected to the introduction tube 23a passing through an upper portion of the reactor 22 and a lower portion of the introduction tube 23a and includes a shower head 23b having a plurality of shower apertures, so that substantial pre-heating and mixing of the introducing chemical source gas are not performed and the wafer "W" which is loaded onto the stage 24 cannot be substantially flooded by the chemical source gas, and so the uniformity level of the compound thin film is lowered.

In addition, since the wafer "W" mounted on the stage is directly exposed to the lower portion of the shower head, the wafer "W" is not substantially exposed to the chemical source gas, so that the uniformity level of the thin film is lowered.

Moreover, since the waste gas by-product of the chemical reaction is exhausted from the outlet, and the gas in the reactor cannot be exhausted at a desired speed, the remaining waste gas affects the quality of the thin film.

The present invention is intended as a solution. In particular it is intended to achieve an even temperature distribution within the reactor so that a uniform thickness thin film can be deposited, on a wafer, without having substantial pin-hole defects.

The apparatus for plasma enhanced low pressure chemical vapour deposition considered herein is of the type, which is described for example in United Kingdom Patent Application GB-A-2256085, comprising:
a supporting base;
a reactor disposed on said supporting base, which reactor is closed at its upper extremity;
a chemical source gas introducer for introducing a chemical source gas into the upper portion space of said reactor;
a stage for supporting a wafer, within said reactor, and to serve as an anode;
stage heating means, incorporated in said stage, for heating the wafer; and
a cathode.

In accordance with the present invention, this apparatus is characterised by:
reactor heating means spaced from and surrounding the upper extremity and side wall of said reactor; and
a heat transfer and electrode member, to serve as said cathode, surrounding the upper extremity and side wall of said reactor, disposed between said reactor heating means and said reactor.

As thus characterised, this apparatus includes a reactor heating means surrounding the reactor. Pre-heating of the source gas, and maintenance of the temperature of the source gas in the reaction space, can therefore be effected.

As thus characterised, this apparatus also includes an (indirect) heat transfer member interposed between the reactor heating means and the reactor. Since this prevents direct irradiation by the surrounding reactor heating means, of the reactor wall, and the contained source gas, a more even heating effect and thus a more even temperature distribution can be achieved. This therefore results in a more uniform deposited thin film thickness and a reduction, or even elimination in the best case, of pin-hole defects in the deposited thin film. Since this heat transfer member is also an electrode, no additional provision of an electrode for the cathode is required.

In accordance with the present invention there are also provided a method of preparing a semiconductor wafer and a method of producing a semiconductor device by the same. These methods are defined by the accompanying claims.

In the accompanying drawings:
Fig. 1 is a cross-sectional view showing a conventional low pressure chemical vapour deposition apparatus;
Fig. 2 is a cross-sectional view showing a conventional plasma assisted low pressure chemical vapour deposition apparatus;
Fig. 3 is a cross-sectional view showing a low pressure chemical vapour deposition apparatus of a first embodiment according to the present invention;
Fig. 4 is a cross-sectional view showing a low pressure chemical vapour deposition apparatus of a second embodiment according to the present invention;
Fig. 5 is a cross-sectional view of a low pressure chemical vapour deposition apparatus of a third embodiment according to the present invention;
Fig. 6 is a cross-sectional view of a low pressure chemical vapour deposition apparatus of a fourth embodiment according to the present invention;
Fig. 7 is a cross-sectional view of a low pressure chemical vapour deposition apparatus of a fifth embodiment according to the present invention; and
Fig. 8 is a partial enlarged cross-sectional view showing a stage and gas distribution plate which can be incorporated in any of the foregoing embodiments.

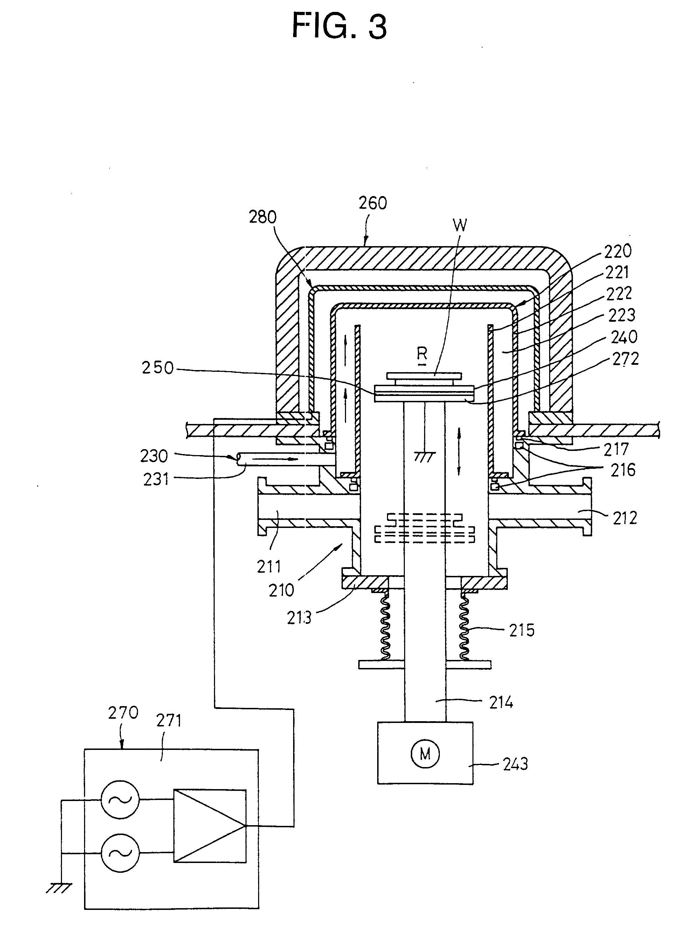

Fig. 3 shows a plasma enhanced low pressure chemical vapour deposition apparatus of a first embodiment according to the present invention, which includes a supporting base 210 having a wafer inlet 211 formed at one side thereof and an outlet 212 formed at the other side thereof for exhausting reaction substances therethrough, a reactor 220 disposed above the supporting base 210 and having a reaction region "R" formed therewithin, a source gas introducer 230 connected to the upper portion of the reactor 220 for introducing the chemical source gas into the reactor 220, a stage 240, on which the wafer "W" is mounted, being movable within a range between a loading/unloading position and a deposition position, and a stage heating member 250 disposed in the stage 240 for heating the wafer "W". Here, this embodiment further includes a reactor heating member 260 disposed at a periphery of the reactor 220 for heating the reactor 220. In addition, there are further provided a stage rotation member 243 for rotating the stage 240 and an electrode member 280 disposed between the reactor 220 and the reactor heating member 260.

The lower aperture of the supporting base 210 can be opened/closed by the opening/closing plate 213. A lifting/lowering ram 214 passes through to the stage 240 and disposed in the opening/closing plate 213.

The reactor 220 includes an upper portion- and lower portion-opened hollow inner tube 221, an upper portionclosed and lower portion-opened outer tube 22, and a chemical source gas flowing path 223 formed between the inner and outer tubes 221 and 222.

Here, the upper portion of the inner tube 221 is lower than that of the outer tube 222, and the chemical source gas flowing path 223 and the reaction region "R" are connected to each other through the space between the inner and outer tubes 221 and 222.

The chemical source gas introducer 230 includes an introducer 231 connected to a lower portion of the chemical source gas flowing path 223.

The lifting/lowering ram 214 for lifting/lowering the stage 240 is rotatable by the stage rotation member 243 and is directed to executing a lifting/lowering operation and a rotation operation, respectively.

The stage heating member 250 is disposed, within the inner upper portion of the stage 240 and is directed to heating the wafer "W" which is mounted on the substrate 240.

The reactor heating member 260 winds around the upper portion and walls of the reactor 220 and is mounted to be lower than the lower surface of the stage 240.

Here, the reactor heating member 260 can be a commonly used electric heater, or it can be directed to heating and circulating ethylene glycol by providing a jacket.

An electrode 280 is disposed between the upper surfaces of the reactor 220 and the reactor heating member 260.

The electrode 280 is formed with a certain material having conductivity and having a characteristic that the transmission of the heat of the reactor heating means to the interior of the reactor 220 is reduced, that is, the heat thereof is indirectly transferred to the interior thereof. This electrode may be formed of SiC material, for example.

In the drawings, reference numeral 215 denotes a flexible dust cover, and 216 denotes a cooling water circulation channel, 217 denotes a packing provided between the supporting base 210 and the lower portion of the inner and outer tubes 221 and 222.

The operation of the plasma enhanced low pressure chemical vapour deposition apparatus will now be explained with reference to the accompanying drawings.

To begin with, the stage 240 is lowered down to the loading/unloading position by the lifting/lowering ram 214. Thereafter, in a state that a predetermined pressure in the reactor is maintained by a vacuum pump (not shown), the wafer "W" is placed on the stage 240 through the wafer inlet 211, and the substrate 240 is lifted up to the deposition position by the lifting/lowering ram 214.

Thereafter, the stage heating member 250 and the reactor heating member 260 are driven. The chemical source gas is introduced into the reactor 220 while heating the wafer "W" placed on the stage 240 and the reactor at a temperature of 100 to 1,100°C.

The chemical source gas introducer 231 introduced into the chemical source gas introducer 230 is introduced into the reaction region "R" through a chemical source gas flow path 223 formed between the inner and outer tubes 221 and 222 of the introduction tube 231.

The chemical source gas is substantially pre-heated as it passes along the chemical source gas flow path 223, and the chemical source gas in the reactor 220 is heated by a predetermined temperature by the reactor heating member 260 and is reacted in the reactor so as to deposit a compound thin film on the wafer "W" mounted on the substrate 240.

Since the chemical source gas in the above-mentioned process is substantially preheated in the chemical source gas flow path 223 and is introduced into the reaction region "R" of the reactor 220, so that temperature differences between gas and wafer are reduced, it is possible to obtain a better thin film without pin holes and cracks, and with better step coverage.

In addition, since this embodiment of the present invention provides the substrate rotation member 243 in the lifting/lowering ram 214 for lifting/lowering the substrate 240 so as to rotate the substrate, it is possible to obtain more even thin film by a uniform chemical source gas flow with respect to the wafer "W".

Meanwhile, since this embodiment of the present invention provides the plasma generator 270 connected to the reactor 220 and the stage 240 for generating plasma in the reaction region "R" by applying a high frequency voltage between the reactor 220 and the stage 240, so that a better thin film deposition can be achieved by expediting the reaction of the chemical source gas in the reactor 220.

That is, when the plasma generator 271 is driven, a high frequency voltage is applied between the indirect electric heater and electrode member 280 formed of SiC or carbon materials and the electrode 272 disposed at the stage 240, and plasma is generated therebetween, so that the chemical source gas in the chemical source gas flowing path 223 is substantially pre-heated, and the reaction of the chemical source gas is more expedited by the plasma discharging Here, there is no need to include additionally an electrode at the side of the reactor 220, thus reducing the number of parts. In addition, it is possible to simplify the assembly line, and fabrication of the product is not costly.

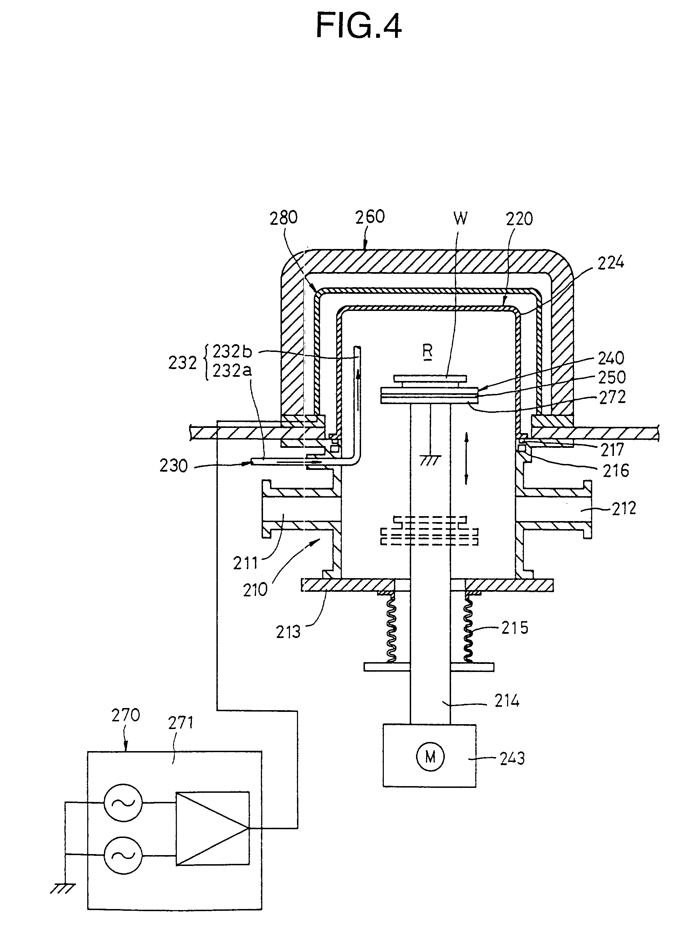

Fig. 4 shows a plasma enhanced low pressure chemical vapour deposition apparatus of a second embodiment according to the present invention. This second embodiment of the present invention is directed to changing the construction of the reactor 220 and the chemical source gas introducer 230. Otherwise, the construction, except for the above-mentioned elements, is the same as in the first embodiment and thus the description of the common parts thereof will be omitted.

The plasma enhanced low pressure chemical vapour apparatus of the second embodiment includes a reactor 220 having a lower portion-opened and upper portion-closed tube 224, a horizontal section 232a extended to the interior of the reactor 220 and passing through a side wall of the supporting base 210, and an introduction tube 232 integral with a vertical section 232b which is upwardly curved from the inner side of the horizontal section 232a.

Here, the upper portion of the vertical section 232b of the introduction tube 232 is higher than that of the stage.

This embodiment of the present invention is directed to introducing the chemical source gas into the upper portion of the reaction region "R" and has a simpler tube 224, so that the chemical source gas is substantially heated through the vertical section 232b. As a result, this embodiment can achieve a similar result to the first embodiment.

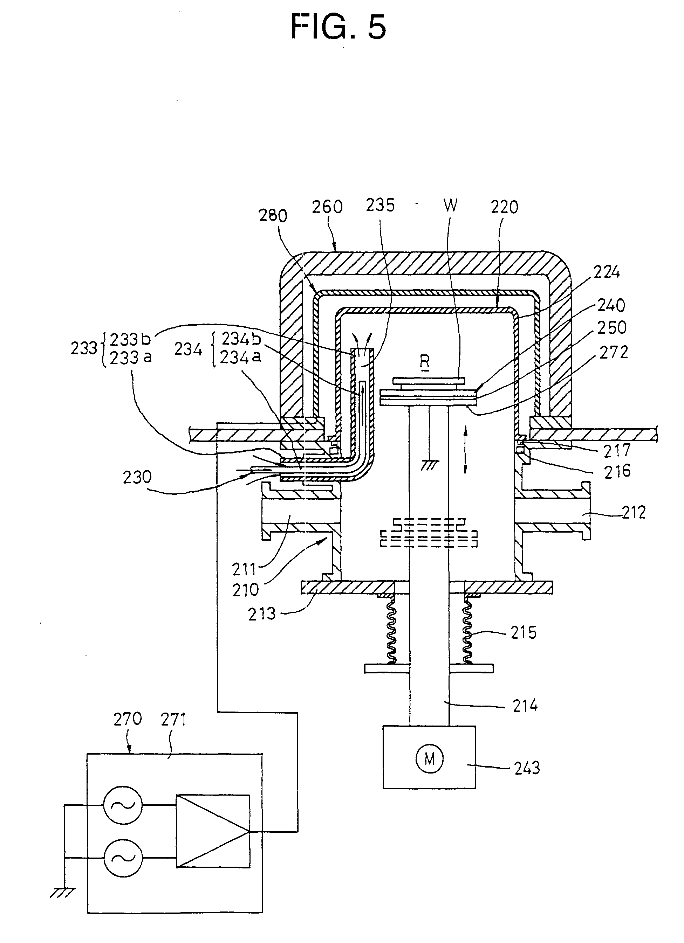

Fig. 5 shows a plasma enhanced low pressure chemical vapour deposition apparatus of the third embodiment according to the present invention. This embodiment is directed to providing another variant of the chemical source gas introducer 230, which includes a horizontal section 233a passing through the side wall of the supporting base, an outer introduction tube 233 having a vertical section 233b upwardly curved from the inner end of the horizontal section 233a and a great diameter, and an inner introduction tube 234 having a horizontal section 234a and a vertical section 234b which are inserted into the interior of the horizontal section 233a and the vertical section 233b of the outer introduction tube 233, so that various kinds of chemical source gases can be introduced into the reactor through an introduction path between the inner and outer introduction tubes 234 and 233 and an introduction tube of the interior of the inner introduction tube 234, and thus various kinds of thin film depositions can be achieved.

The upper portion of the vertical section 233b of the outer introduction tube 233 is higher than the deposition position of the stage. In addition, the height of the upper portion of the vertical section of the inner introduction tube 234 is preferably similar to the deposition position of the stage because the chemical source gas introduced through above two introduction paths is well mixed at a space between the upper portion of the vertical section of the inner introduction tube 234 and the upper portion of the vertical section 233b of the outer introduction tube 233, so that a better thin film deposition can be achieved.

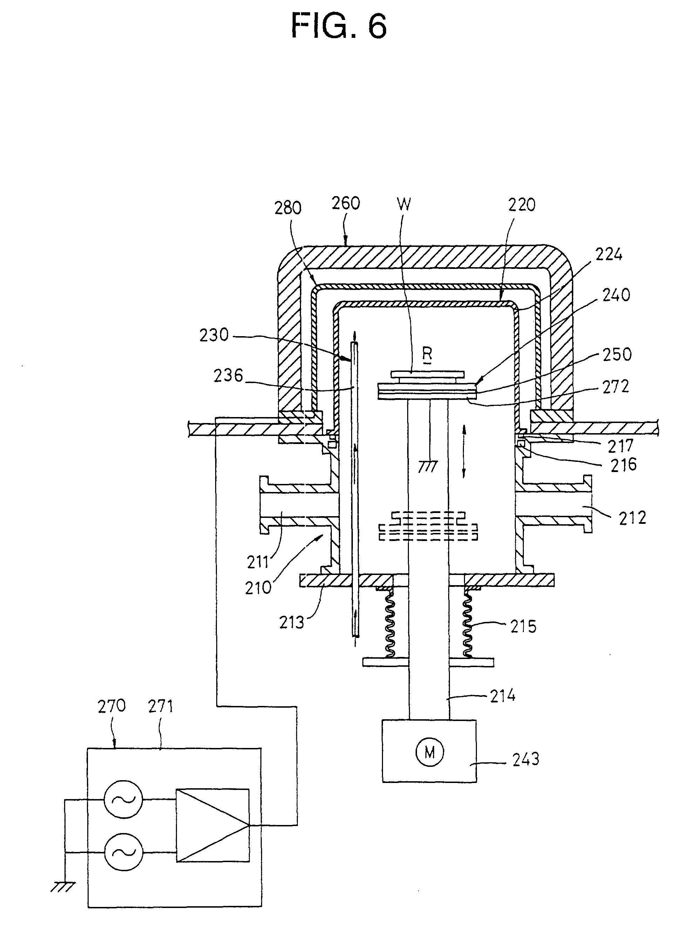

Fig. 6 shows a plasma enhanced low pressure chemical vapour deposition apparatus of a fourth embodiment according to the present invention, which is directed to changing the construction of the chemical source gas introducer 230.

That is, the chemical source gas introducer 230 of this embodiment includes an introduction tube 236 of which the upper portion thereof is extended to a predetermined portion higher than the deposition position of the stage and vertically passes through the opening/closing plate 213 for opening/closing the lower portion of the deposition base 210.

Since the chemical source gas is substantially heated through the introduction tube 236 by the heat of the reactor heating member 260 and is introduced into the reaction region "R", effects similar to the first embodiment can be achieved.

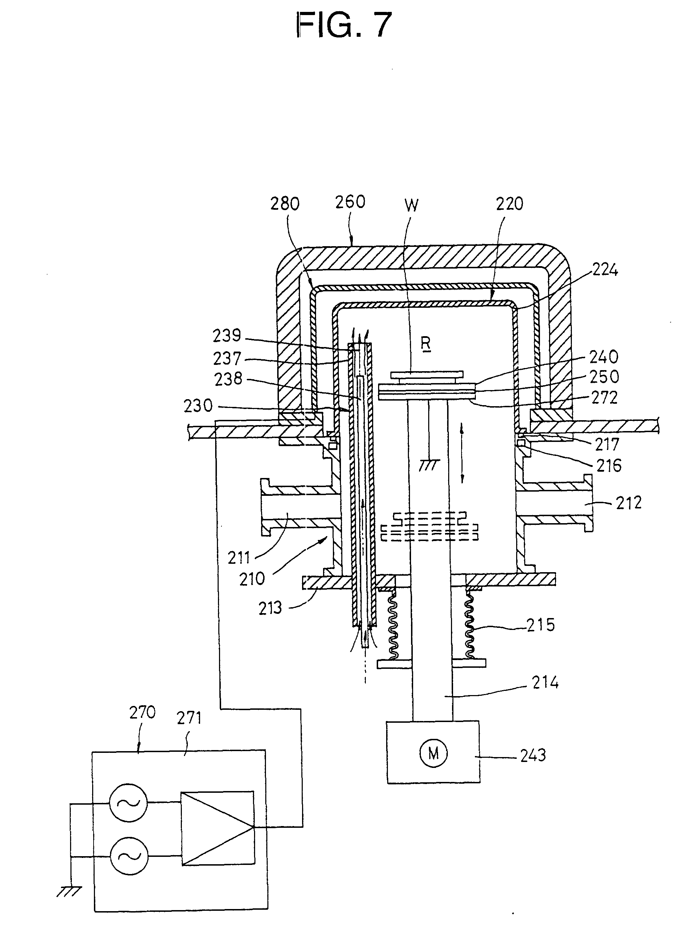

Fig. 7 shows a plasma enhanced low pressure chemical vapour deposition apparatus of a fifth embodiment according to the present invention, which is directed to changing the construction of the chemical source gas introducer 230.

The chemical source gas introducer 230 includes an outer introduction tube 237 of which the upper portion thereof is extended to a predetermined portion higher than the deposition position of the stage, and an inner introduction tube 237 inserted into the interior of the outer introduction tube 237 and of which the height of the upper portion thereof is similar to the deposition position of the stage, so that various kinds of chemical source gases can be introduced through an introduction path between the inner and outer introduction tubes 238 and 237 and an introduction path of the inner introduction tube 238 and can be substantially pre-heated by the heat of the reactor heating member 260, and the different chemical source gases are well mixed in a certain space 239 defined between the inner and outer introduction tubes 238 and 237 and are introduced into the reaction region "R", and thus this embodiment can achieve the same effects as the second embodiment of the present invention.

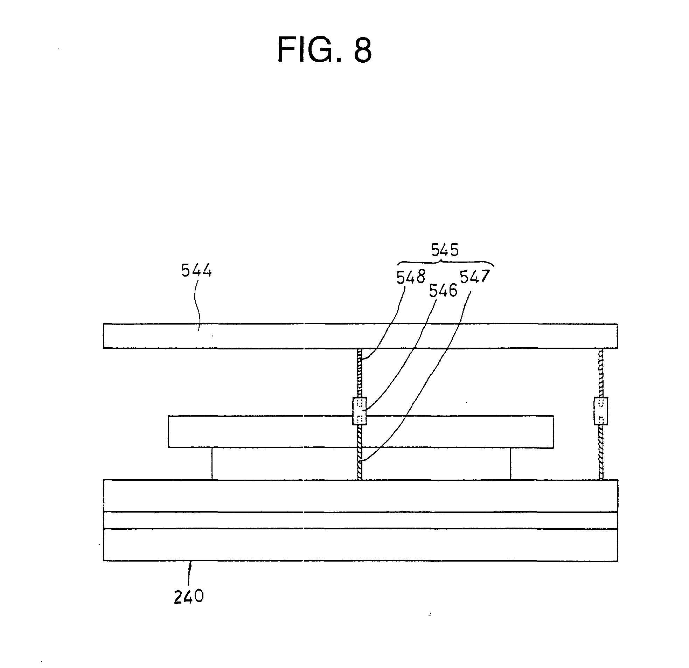

Fig. 8 shows a support stage arrangement which may be employed in each of the foregoing embodiments. The stage 240, in this case, includes a chemical source gas dispersion plate 544 for evenly introducing the chemical source gas over the entire surface of the wafer "W" mounted on the stage 240.

The stage 240 and the dispersion plate 544 are engaged by a gap control member 545 for controlling the gap therebetween.

The gap control member 545 includes threaded bars 547 and 548 connected to the stage 240 and the dispersion plate 544 and a turn buckle-type control knob 546, engaged to the threaded bars 547 and 548. Three sets of the threaded bars 547 and 548 are provided and are disposed so as to prevent any interference from the wafer "W" which is loaded/unloaded through the wafer inlet 211.

The stage 240, as modified, is directed to evenly introducing the chemical source gas over the entire surface of the wafer "W" by preventing the chemical source gas from being directly introduced onto the surface of the wafer "W" in a process that the chemical source gas is introduced into the reaction region "R" and from unevenly and partially introducing onto the surface of the wafer "W" by allowing the chemical source gas to cover the surface of the wafer "W" through the gap formed between the wafer "W" on the stage 240 and the dispersion plate 544, so that an even thickness of a thin film can be achieved.

In addition, a desired thin film can be achieved by controlling the gap between the upper surface of the stage 240 and the dispersion plate 544 in accordance with the conditions of the chemical source gas and the thin film.

## Claims

1. An apparatus for plasma enhanced low pressure chemical vapour deposition comprising:
a supporting base (210);
a reactor (220) disposed on said supporting base, which reactor is closed at its upper extremity;
a chemical source gas introducer (230) for introducing a chemical source gas into the upper portion space (R) of said reactor;
a stage (240) for supporting a wafer (W), within said reactor, and to serve as an anode;
stage heating means (250), incorporated in said stage, for heating the wafer; and
a cathode (280);
characterised by:
reactor heating means (260) spaced from and surrounding the upper extremity and side wall (222) of said reactor (220); and
a heat transfer and electrode member (280), to serve as said cathode, surrounding the upper extremity and side wall of said reactor, disposed between said reactor heating means and said reactor.

2. Apparatus as claimed in claim 1 having:
an inner tube (221) arranged on said supporting base (210) and disposed within said reactor (220); and
a gas introducing tube (231) communicating with the space (223) between said inner tube (221) and the sidewall (221) of said reactor (220); wherein
said gas introducing tube (231), said inner tube (221), and the sidewall (221) of said reactor (220), together provide said chemical source gas introducer (230) for introducing a chemical source gas into the upper portion space (R) of said reactor (220).

3. Apparatus, as claimed in claim 1, having, as chemical source gas introducer (230), an introduction tube (232) of which the upper portion open end (232b) thereof opens at a periphery of the upper portion space (R) of said reactor (220).

4. Apparatus as claimed in claim 3 wherein said introduction tube (232) has a horizontal portion passing through the sidewall of said supporting base (210).

5. Apparatus as claimed in claim 3, wherein said introduction tube (232) passes vertically through the base extremity (213) of said supporting base (210).

6. Apparatus as claimed in any of claims 3 to 5 wherein said introduction tube (232) has an outer tube part (233) and an inner tube part (234), whereby respective gas flow paths are defined by the interior of said inner tube part (234) and by the space between said outer tube part (233) and said inner tube part (234).

7. Apparatus as claimed in claim 6 wherein the upper portion open end (234b) of said inner tube part (234) is located below the upper portion open end (233b) of said outer tube part (233).

8. Apparatus as claimed in any preceding claim wherein said stage (240) is movable between a wafer loading and unloading position and a deposition position, which deposition position is within said reactor (220).

9. Apparatus as claimed in any preceding claim wherein said stage (240) is rotatable about a vertical axis.

10. Apparatus, as claimed in any preceding claim, having a gas dispersion plate (544), located over said stage (240;540), with a gap therebetween, for dispersing the chemical source gas over the entire surface of the wafer (W).

11. Apparatus, as claimed in claim 10, wherein said gas dispersion plate (544) is provided with a gap adjustment means (545) for adjusting the gap between said gas dispersion plate and the upper surface of said stage (540) which is to support the wafer (W).

12. Apparatus, as claimed in any preceding claim, having a high frequency electricity generator (270) connected between the anode, provided by said stage (240), and the cathode, provided by said heat transfer and electrode member (280), for forming a plasma by exciting the chemical source gas under low pressure within said reactor (220).

13. A method of preparing a semiconductor wafer (W) by plasma enhanced low pressure chemical vapour deposition comprising:
positioning the wafer (W) in the reaction space (R) of a reactor (220) using a supporting stage (240);
heating the wafer by applying heat to said supporting stage;
introducing a source gas into the upper portion space of said reactor (220); and
generating a plasma, in the vicinity of the wafer, by applying a high frequency drive signal between the supporting stage, acting as anode, and a cathode (280), to promote reaction and to deposit thin film on the exposed surface of said wafer;
**characterised in that**:
heat is also applied to the reactor (220) and to the source gas from an external reactor heating means (260) via a heat transfer member (280), acting as cathode, and which is located over the upper extremity of the reactor and surrounding -the sidewall thereof, in the space between said reactor and said external reactor heating means.

14. A method of producing a semiconductor device which includes:
preparing a semiconductor wafer (W) by the method of claim 13;
processing said wafer to produce integrated circuit structures; and
dividing said wafer into dice, each die including an integrated circuit.

## Patentansprüche

1. Vorrichtung zur plasmaunterstützten chemischen Niederdruckbedampfung, umfassend:
einen tragenden Untersatz (210);
eine auf dem tragenden Untersatz angeordnete Reaktionskammer (220), die an ihrem oberen Ende abgeschlossen ist;
eine Zuführung (230) für ein Gas einer chemischen Quelle zum Einführen eines Gases einer chemischen Quelle in den oberen Raumbereich (R) der Reaktionskammer;
eine Plattform (240) zum Tragen eines Wafers (W) innerhalb der Reaktionskammer und zur Verwendung als Anode;
eine in die Plattform eingearbeitete Plattform-Heizvorrichtung (250), um den Wafer zu heizen; und
eine Kathode (280);
**gekennzeichnet** durch:
eine das obere Ende und die Seitenwand (222) der Reaktionskammer (220) umgebende und davon beabstandete Heizvorrichtung (260) für die Reaktionskammer; und
ein Wärmeübertragungs- und Elektrodenglied (280), das als Kathode dient und das obere Ende und die Seitenwand der Reaktionskammer umgibt und zwischen der Heizvorrichtung für die Reaktionskammer und der Reaktionskammer angeordnet ist.

2. Vorrichtung nach Anspruch 1 mit:
einer auf dem tragenden Untersatz (210) angebrachten und innerhalb der Reaktionskammer (220) angeordneten inneren Röhre (221); und
einer Gaszuführungsröhre (231), die mit dem Raum (223) zwischen der inneren Röhre (221) und der Seitenwand (222) der Reaktionskammer (220) in Verbindung steht; wobei
die Gaszuführungsröhre (231), die innere Röhre (221) und die Seitenwand (222) der Reaktionskammer (220) zusammen die Zuführung (230) für Gas einer chemischen Quelle zur Verfügung stellen, um ein Gas einer chemischen Quelle dem oberen Raumbereich (R) der Reaktionskammer (220) zuzuführen.

3. Vorrichtung nach Anspruch 1 mit einer Zuführungsröhre (232) als Zuführung (230) für ein Gas einer chemischen Quelle, deren offenes Ende (232b) an ihrem oberen Bereich sich in der Peripherie des oberen Raumbereichs (R) der Reaktionskammer (220) öffnet.

4. Vorrichtung nach Anspruch 3, wobei die Zuführungsröhre (232) einen horizontalen Abschnitt aufweist, der durch die Seitenwand des tragenden Untersatzes (210) hindurchgeht.

5. Vorrichtung nach Anspruch 3, wobei die Zuführungsröhre (232) durch das Basisende (213) des tragenden Untersatzes (210) vertikal hindurchgeht.

6. Vorrichtung nach einem der Ansprüche 3 bis 5, wobei die Zuführungsröhre (232) einen äußeren Röhrenteil (233) und einen inneren Röhrenteil (234) aufweist, wobei durch das Innere des inneren Röhrenteils (234) und durch den Raum zwischen dem äußeren Röhrenteil (233) und dem inneren Röhrenteil (234) entsprechende Gasströmungspfade definiert sind.

7. Vorrichtung nach Anspruch 6, wobei das offene Ende (234b) des oberen Abschnitts des inneren Röhrenteils (234) unterhalb des offenen Endes (233b) des oberen Abschnitts des äußeren Röhrenteils (233) angeordnet ist.

8. Vorrichtung nach einem der vorhergehenden Ansprüche, wobei die Plattform (240) zwischen einer Waferlade- und -entladeposition und einer Bedampfungsposition bewegbar ist, wobei sich die Bedampfungsposition innerhalb der Reaktionskammer (220) befindet.

9. Vorrichtung nach einem der vorhergehenden Ansprüche, wobei die Plattform (240) um eine vertikale Achse drehbar ist.

10. Vorrichtung nach einem der vorhergehenden Ansprüche mit einer Gasverteilungsplatte (544), die oberhalb der Plattform (240; 540) mit einem Abstand dazu angeordnet ist, um das Gas einer chemischen Quelle über die gesamte Oberfläche des Wafers (W) zu verteilen.

11. Vorrichtung nach Anspruch 10, wobei die Gasverteilungsplatte (544) mit einer Abstandseinstellvorrichtung (545) zum Einstellen des Abstands zwischen der Gasverteilungsplatte und der oberen Oberfläche der Plattform (540), die zum Tragen des Wafers (W) dient, vorgesehen ist.

12. Vorrichtung nach einem der vorhergehenden Ansprüche mit einem Hochfrequenzstrom-Erzeuger (270), der zwischen die durch die Plattform (240) gebildete Anode und die durch das Wärmeübertragungs- und -elektrodenglied (280) gebildete Kathode geschaltet ist, um durch Anregung des Gases einer chemischen Quelle unter niedrigem Druck innerhalb der Reaktionskammer (220) ein Plasma auszubilden.

13. Verfahren zum Behandeln eines Halbleiterwafers (W) durch plasmaunterstützte chemische Niederdruck-Bedampfung, umfassend:
Anordnen des Wafers (W) im Reaktionsraum (R) einer Reaktionskammer (220) mittels einer tragenden Plattform (240);
Erhitzen des Wafers durch Zuführen von Wärme an die tragende Plattform;
Zuführen eines Quellengases in den oberen Raumbereich der Reaktionskammer (220); und
Erzeugen eines Plasmas in der Nähe des Wafers durch Anlegen eines Hochfrequenz--Antriebssignals zwischen der als Anode wirkenden tragenden Plattform und einer Kathode (280), um eine Reaktion zu fördern und einen dünnen Film auf der exponierten Oberfläche des Wafers aufzubringen;
**dadurch gekennzeichnet,** daß:
weiterhin der Reaktionskammer (220) und dem Quellengas von einer externen Reaktionskammer-Heizvorrichtung (260) über ein als Kathode wirkendes Wärmeübertragungsglied (280) Wärme zugeführt wird, das oberhalb des oberen Endes der Reaktionskammer angeordnet ist und deren Seitenwand im Raum zwischen der Reaktionskammer und der externen Reaktionskammer-Heizvorrichtung umgibt.

14. Verfahren zur Herstellung eines Halbleitererzeugnisses, beinhaltend:
Behandeln eines Halbleiterwafers (W) nach dem Verfahren gemäß Anspruch 13;
Verarbeiten dieses Wafers zur Herstellung von Anordnungen integrierter Schaltkreise; und
Unterteilen des Wafers in Plättchen, wobei jedes Plättchen einen integrierten Schaltkreis beinhaltet.

## Revendications

1. Appareil pour un dépôt chimique en phase vapeur à basse pression activé par plasma, comportant:
une embase (210) de support;
un réacteur (220) disposé sur ladite embase de support, lequel réacteur est fermé à son extrémité supérieure;
un dispositif (230) d'introduction d'un gaz de source chimique pour l'introduction d'un gaz de source chimique dans l'espace de la partie supérieure (R) dudit réacteur;
une platine (240) destinée à supporter une tranche (W), à l'intérieur dudit réacteur, et à servir d'anode;
un moyen (250) de chauffage de la platine, incorporé dans ladite platine, pour chauffer la tranche; et
une cathode (280) ;
caractérisé par:
un moyen (260) de chauffage du réacteur espacé de, et entourant, l'extrémité supérieure et la paroi latérale (222) dudit réacteur (220); et
un élément (280) de transmission de chaleur et à électrode destiné à servir en tant que ladite cathode, entourant l'extrémité supérieure et la paroi latérale dudit réacteur, disposé entre ledit moyen de chauffage du réacteur et ledit réacteur.

2. Appareil selon la revendication 1, ayant:
un tube intérieur (221) agencé sur ladite embase de support (210) et disposé à l'intérieur dudit réacteur (220); et
un tube (231) d'introduction de gaz communiquant avec l'espace (223) entre ledit tube intérieur (221) et la paroi latérale (221) dudit réacteur (220); dans lequel
ledit tube (231) d'introduction de gaz, ledit tube intérieur (221) et la paroi latérale (221) dudit réacteur (220) forment ensemble ledit dispositif (230) d'introduction de gaz de source chimique pour introduire un gaz de source chimique dans l'espace de la partie supérieure (R) dudit réacteur (220).

3. Appareil selon la revendication 1, ayant, en tant que dispositif (230) d'introduction d'un gaz de source chimique, un tube d'introduction (232) dont l'extrémité ouverte (232b) de la partie supérieure débouche à une périphérie de l'espace de la partie supérieure (R) dudit réacteur (220).

4. Appareil selon la revendication 3, dans lequel ledit tube d'introduction (232) comporte une partie horizontale passant à travers la paroi latérale de ladite embase (210) de support.

5. Appareil selon la revendication 3, dans lequel ledit tube d'introduction (232) passe verticalement à travers l'extrémité (213) de base de ladite embase (210) de support.

6. Appareil selon l'une quelconque des revendications 3 à 5, dans lequel ledit tube d'introduction (232) comporte une partie de tube extérieure (233) et une partie de tube intérieure (234), grâce à quoi des trajets d'écoulement de gaz respectifs sont définis par l'intérieur de ladite partie de tube intérieure (234) et par l'espace entre ladite partie de tube extérieure (233) et ladite partie de tube intérieure (234).

7. Appareil selon la revendication 6, dans lequel l'extrémité ouverte (234b) de la partie supérieure de ladite partie de tube intérieure (234) est placée en dessous de l'extrémité ouverte (233b) de la partie supérieure de ladite partie de tube extérieure (233).

8. Appareil selon l'une quelconque des revendications précédentes, dans lequel ladite platine (240) peut être déplacée entre une position de chargement et de déchargement d'une tranche et une position de dépôt, laquelle position de dépôt se trouve à l'intérieur dudit réacteur (220).

9. Appareil selon l'une quelconque des revendications précédentes, dans lequel ladite platine (240) peut tourner autour d'un axe vertical.

10. Appareil selon l'une quelconque des revendications précédentes, ayant une plaque (544) de dispersion de gaz, placée au-dessus de ladite platine (240; 540), avec un espace entre elles, pour disperser le gaz de source chimique sur toute la surface de la tranche (W).

11. Appareil selon la revendication 10, dans lequel ladite plaque (544) de dispersion de gaz est pourvue d'un moyen (545) de réglage d'intervalle pour régler l'intervalle entre ladite plaque de dispersion de gaz et la surface supérieure de ladite platine (540) qui doit supporter la tranche (W).

12. Appareil selon l'une quelconque des revendications précédentes, ayant un générateur (270) d'électricité à haute fréquence connecté entre l'anode, procurée par ladite platine (240), et la cathode, procurée par ledit élément (280) de transmission de chaleur et à électrode, pour former un plasma par excitation du gaz de source chimique sous basse pression à l'intérieur dudit réacteur (220).

13. Procédé de préparation d'une tranche semi-conductrice (W) par dépôt chimique en phase vapeur à basse pression activé par plasma, comprenant:
le positionnement de la tranche (W) dans l'espace de réaction (R) d'un réacteur (220) en utilisant une platine de support (240) ;
le chauffage de la tranche par l'application de chaleur à ladite platine de support;
l'introduction d'un gaz de source dans l'espace de la partie supérieure dudit réacteur (220); et
la génération d'un plasma, au voisinage de la tranche, par l'application d'un signal d'attaque à haute fréquence entre la platine de support, agissant en tant qu'anode, et une cathode (280), afin de stimuler une réaction et de déposer un film mince sur la surface à découvert de ladite tranche;
**caractérisé en ce que**:
de la chaleur est également appliquée au réacteur (220) et au gaz de source à partir d'un moyen extérieur (260) de chauffage du réacteur par l'intermédiaire d'un élément (280) de transmission de la chaleur, agissant en tant que cathode, et qui est placé au-dessus de l'extrémité supérieure du réacteur et entoure sa paroi latérale, dans l'espace entre ledit réacteur et ledit moyen extérieur de chauffage du réacteur.

14. Procédé de production d'un dispositif semiconducteur qui comprend:
la préparation d'une tranche semi-conductrice (W) par le procédé de la revendication 13;
le traitement de ladite tranche pour produire des structures de circuits intégrés; et
la division de ladite tranche en dés, chaque dé comprenant un circuit intégré.
